Europäisches Patentamt

European Patent Office

Office européen des brevets

(19)

(11) **EP 0 525 873 B1**

(12) **EUROPEAN PATENT SPECIFICATION**

(45) Date of publication and mention
of the grant of the patent:
**18.12.1996 Bulletin 1996/51**

(51) Int Cl.⁶: **H03F 1/22**

(21) Application number: **92202208.2**

(22) Date of filing: **20.07.1992**

(54) **Amplifier arrangement**

Verstärkerschaltung

Circuit amplificateur

(84) Designated Contracting States:
**DE FR GB IT**

(30) Priority: **30.07.1991 EP 91201969**

(43) Date of publication of application:
**03.02.1993 Bulletin 1993/05**

(73) Proprietor: **Philips Electronics N.V.**
**5621 BA Eindhoven (NL)**

(72) Inventors:
 • **Bult, Klaas**
  **NL-5656 AA Eindhoven (NL)**
 • **Geelen, Godefridus J.G.M.**
  **NL-5656 AA Eindhoven (NL)**

(74) Representative: **Schoonheijm, Harry Barend et al**
**INTERNATIONAAL OCTROOIBUREAU B.V.,**
**Prof.Holstlaan 6**
**5656 AA Eindhoven (NL)**

(56) References cited:
**EP-A- 0 397 240**  **GB-A- 2 114 842**

 • **1990 IEEE INTERNATIONAL SYMPOSIUM ON CIRCUITS AND SYSTEMS vol. 2, 1 May 1990, New Orleans, LA, pp 1173-1176; U. GATTI ET AL.: 'A NOVEL CMOS LINEAR TRANSCONDUCTANCE CELL FOR CONTINUOUS-TIME FILTERS'**

## Description

The invention relates to an amplifier arrangement comprising a first transistor having a control electrode coupled to an input terminal for receiving an input signal, having a first main electrode coupled to a first supply-voltage terminal, and having a second main electrode, a second transistor having a control electrode, having a first main electrode coupled to the second main electrode of the first transistor, and having a second main electrode coupled to an output terminal for supplying an output signal, and a control amplifier having an inverting input coupled to the second main electrode of the first transistor and a non-inverting input coupled to a reference voltage, and having an output coupled to the control electrode of the second transistor.

Such an amplifier arrangement can be used in general for amplifying a signal in integrated semiconductor circuits.

Such an amplifier arrangement is known *inter alia* from European Patent Application EP-A 0,397,240. The known amplifier arrangement amplifies an input signal applied to the input terminal so as to obtain an output signal on the output terminal, the control amplifier maintaining a substantially constant potential on the second main electrode of the first transistor. As a result of the substantially constant potential the known amplifier arrangement can provide a high gain, although in some cases the output impedance and hence the internal gain of the amplifier arrangement are too low, which is a disadvantage.

It is an object of the invention to provide an amplifier arrangement having a very high output impedance and a ditto internal gain.

It is another object of the invention to provide an amplifier arrangement which has an optimum dynamic range and/or forms a very compact device in comparison with the prior art.

An amplifier arrangement in accordance with the invention is characterised in that the amplifier arrangement further comprises correction means for correcting a first potential on the second main electrode of the first transistor depending upon a second potential on the control electrode of the first transistor, in such manner that in operation the first transistor is kept at a desired point of saturation. The invention is based on the recognition of the fact that in order to realise a very high output impedance the first potential on the second main electrode of the first transistor should be dependent on the second potential of a signal source coupled to the input terminal, *i.e.* the potential on the control electrode of the first transistor, to such an extent that the first transistor is kept at the same desired point of saturation. As the correction means couple the first potential on the second main electrode of the first transistor to the second potential on the control electrode of the first transistor, the first transistor will be operated at a desired point of saturation depending on the input signal applied to the input terminal, yielding a maximum gain and a maximum output signal swing.

A first embodiment of an amplifier arrangement in accordance with the invention may be characterised in that the correction means comprise adaptation means and a current-sensing circuit (N3) for generating a current related to a current through the first transistor (N1), the adaptation means being driven by means of the current generated by the sensing circuit to adapt the first potential.

The proposed embodiment corrects the first potential in dependence on variations of the current through the first transistor which are caused by variations of the second potential on the input terminal.

A second embodiment of an amplifier arrangement in accordance with the invention is characterised in that the correction means comprise a current-mirror circuit (P1, P2, P3) for generating a current related to a current through the first transistor (N1), the adaptation means (N6, N7, N8) being driven by means of said current generated by the current-mirror circuit (PI, P2, P3) to adapt the first potential.

A third embodiment of an amplifier arrangement in accordance with the invention is characterised in that the adaptation means (N6, N7, N8) comprise at least one transistor (N6) which in combination with the first transistor (N1) forms a current path between the first and a second supply voltage terminal, which current path is supplied with current from an output (P3) of the current mirror (P1, P2, P3), the first transistor (N1) and said transistors of the adaptation means being of the same conductivity type.

The above and other (more detailed) features of the invention will now be described and explained more elaborately with reference to the accompanying drawings, in which

Figure 1 shows an embodiment of an amplifier arrangement in accordance with the invention, the amplifier arrangement comprising a simple control amplifier, and
Figure 2 shows a further embodiment of an amplifier arrangement in accordance with the invention, the amplifier arrangement comprising a cascoded control amplifier.

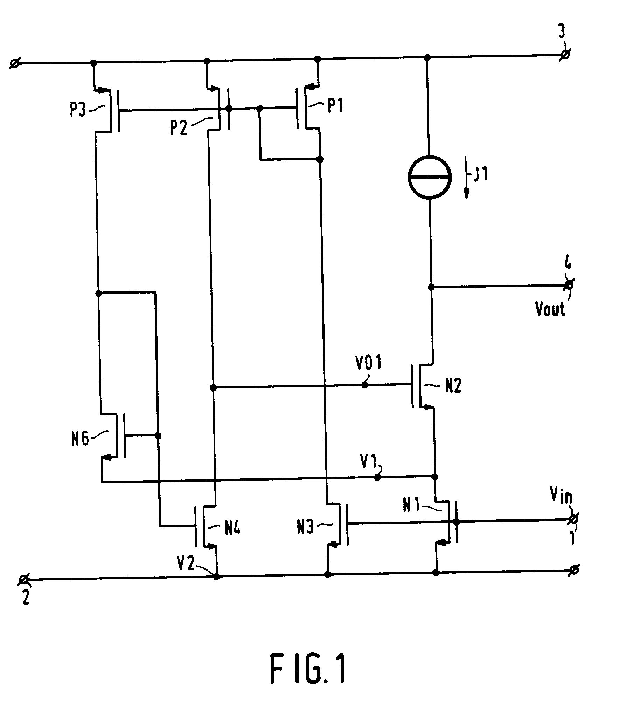

Fig. 1 shows an embodiment of an amplifier arrangement in accordance with the invention, the amplifier arrangement comprising a simple control amplifier. The relevant amplifier arrangement comprises a first transistor N1, a second transistor N2, and a control amplifier (N4), the transistor N1 having a control electrode (gate) coupled to an input terminal 1 for receiving an input signal Vin, a first main electrode (source) coupled to a first supply-voltage terminal 2, and a second main electrode (drain), the transistor N2 having a control electrode (gate), a first main electrode (source) coupled to the drain of the transistor N1, and a second main electrode (drain) coupled to a second supply-voltage terminal 3 *via* a current source J1 and to an output terminal 4 for supplying an output signal Vout. The control amplifier (N4) comprises an inverting input V1 coupled to the drain of the transistor N1, a non-inverting input V2 (in fact the source of the transistor N3) coupled to the supply-voltage terminal 2 for receiving a reference voltage, and an output VO1 coupled to the control electrode (gate) of the transistor N2. The amplifier arrangement further comprises correction means for varying a first potential on the drain of the transistor N1 depending on variations of a second potential on the gate of the transistor N1. The correction means comprise a current-sensing circuit (transistor N3), a current-mirror circuit (P1, P2, P3, P4), and adaptation means (N6) for adapting the first potential. In the present embodiment the gates of the transistors N3 and N1 are interconnected, the sources of these transistors also being connected to one another. Therefore, the current through the transistor N3 is related (proportional) to the current through the transistor N1. The drain of the transistor N3 is connected to the drain of a PMOS transistor P1 of the current mirror P1, P2 and P3. The PMOS transistors P1, P2 and P3 have their sources connected to the supply-voltage terminal 3 and their gates connected to each other, the drain of the transistor P1 being connected to the gate of this transistor.

A variation (for example increase) of the current through the transistor N1 results in the transistor N3 and the current mirror P1, P2 and P3 causing a similar current variation (increase). The variation of the current through the transistor P2 influences the control amplifier transistor N4. The variation of the current through the transistor P3 influences the adaptation means in the form of the transistor N6. The drain of the transistor N1 is connected to the source of the diode-connected transistor N6 *via* the inverting input of the control amplifier (N4). The first potential on the drain of the transistor N1 is now determined by the difference in source-gate voltage differences of the transistors N4 and N6:

$$V1 = |V_{GS\,N4}| - |V_{GS\,N6}|$$

By selecting the length-width ratio of the transistor N4 to be 3 to 9 times, preferably ≈ 5 times, as large as the length-width ratio of the transistor N6, it is achieved that the first potential V1 is dependent on the second potential, *i.e.* the input voltage Vin on the gate of the transistor N1, to such an extent that the transistor N1 operates just at the desired "edge" of saturation.
The L/W ratios of the transistors P3, P2, P1 are a factor of 2 to 3 larger than the L/W ratios of the transistors N3 and N4.

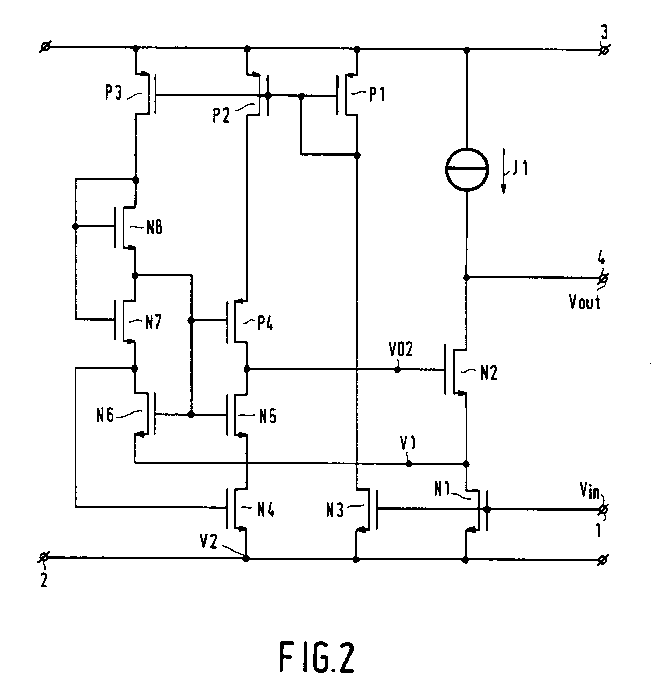

Figure 2 shows a further embodiment of an amplifier arrangement in accordance with the invention, the amplifier arrangement comprising a cascoded control amplifier.

The embodiment shown in Figure 2 comprises a large number of components similar to the components shown in Fig. 1. For this reason these components bear the same references. The relevant components are also connected (to each other) in the same way unless stated otherwise.

A series connection of a P-MOS transistor P4 and an N-MOS transistor N5 is arranged between the drain of the transistor N4 and the drain of the transistor P2, the drain of the transistor N4 and P2 being connected to the source of the transistor N5 and P4 respectively. The drain of the transistor N5 and P5 are connected to one another and to the gate of the transistor N2. The drain of the transistor N6 and P3 are connected to the source of the transistor N7 and the drain of the transistor N8 respectively. The drain of the transistor N7 and the source of the transistor N8 are connected to one another and to the gates of the transistors N6, N5 and P4. The gate of the transistor N4 is connected to the drain of the transistor N6. The gates of the transistors N7 and N8 are connected to the drain of the transistor N8.

The control amplifier (N4) in Fig. 1, which generates the voltage VO1 by means of its current-source section (= the transistor P2), is now formed by cascoding the transistors N5 and N4 and the transistors P2 and P4 and supplies a voltage VO2. The transistors N4, N5 and P4 are suitably biassed by means of the current branch comprising the transistors N1, N6, N7 and N8.

The operation of the arrangement in Fig. 2 is substantially the same as that of the arrangement in Fig. 1. A variation of the current through the transistor N1 now also gives rise to a similar variation of the current through the transistors N3, P1, P2 and P3. However, in the present case the length-width ratio of the transistors N3, N4, N5 and N6, N8 is the same whereas the length-width ratio of the transistor N7 is larger (3 to 9x and preferably 5x as large) than the length-width ratio of the transistor N8.

The first potential V1 on the drain of the transistor N1 is now defined by:

$$V1 = |V_{GS\,N4}| + |V_{GS\,N7}| - |V_{GS\,N8}| - |V_{GS\,N6}|$$

The arrangements shown in Figs. 1 and 2 can be used as electronic modules. The arrangements in effect operate as a fictitious N-MOS transistor yielding an intrinsic gain (gm. ro) of more than 85 dB. The input terminal 1 is the connection for the gate of this transistor, the terminal 2 and the output terminal 4 respectively constituting the source and the drain of this transistor.

An additional advantage of these arrangements is that they do not require external bias voltages, *i.e.* from outside the arrangements, which facilitates integration of the arrangements and simplifies the combination of a plurality of such arrangements in an IC. It is to be noted that the IC area for the transistors N3 to N8 and P1 to P4 is only 20 % of the area of the transistors N1 and N2, thereby enabling such a fictitious transistor to be of a very compact construction.

The invention is not limited to the embodiments shown herein. Within the scope of the invention as set out in the appended claims several modifications are conceivable to those skilled in the art. For example, the transistors shown in the Figures can be replaced by transistors of an opposite conductivity type, yielding a fictitious P-MOS transistor, and the individual parts of the amplifier arrangement can be constructed in several ways. A plurality of such fictitious P-MOS and N-MOS transistors can be integrated on one substrate so that these fictitious P-MOS and N-MOS transistors can be combined to form circuit arrangements in much the same way as normal P-MOS and N-MOS transistors which are known *per se*.

**Claims**

1. An amplifier arrangement comprising a first transistor (N1) having a control electrode coupled to an input terminal (1) for receiving an input signal (Vin), having a first main electrode coupled to a first supply-voltage terminal (2), and having a second main electrode, a second transistor (N2) having a control electrode, having a first main electrode coupled to the second main electrode of the first transistor (N1), and having a second main electrode coupled to an output terminal (4) for supplying an output signal (Vout), and a control amplifier (N4, N5, P2, P4) having inverting input (V1) coupled to the second main electrode of the first transistor (N1) and a non-inverting input coupled to a reference voltage (2), and having an output (VO) coupled to the control electrode of the second transistor (N2), characterised in that the amplifier arrangement further comprises correction means (N3, N6, N7, N8, P1, P2, P3, P4) for correcting a first potential on the second main electrode of the first transistor (N1) depending upon a second potential on the control electrode of the first transistor (N1), in such manner that in operation the first transistor (N1) is kept at a desired point of saturation.

2. An amplifier arrangement as claimed in Claim 1, characterised in that the correction means comprise adaptation means (N6, N7, N8) and a current-sensing circuit (N3) for generating a current related to a current through the first transistor (N1), the adaptation means (N6, N7, N8) being driven by means of the current generated by the sensing circuit to adapt the first potential.

3. An amplifier arrangement as claimed in Claim 1 or 2, characterised in that the correction means comprise a current-mirror circuit (P1, P2, P3) for generating a current related to a current through the first transistor (N1), the adaptation means (N6, N7, N8) being driven by means of said current generated by the current-mirror circuit (P1, P2, P3) to adapt the first potential.

4. An amplifier arrangement as claimed in Claim 2 or 3, characterised in that the adaptation means (N6, N7, N8) comprise at least one transistor (N6) which in combination with the first transistor (N1) forms a current path between the first and a second supply voltage terminal, which current path is supplied with current from an output (P3) of the current mirror (P1, P2, P3), the first transistor (N1) and said transistors of the adaptation means being of the same conductivity type.

5. An amplifier arrangement as claimed in Claim 2, 3 or 4, characterised in that the control amplifier (N4, N5, P4, P2) is supplied with current from a further output (P2) of the current mirror (P1, P2, P3).

6. An amplifier arrangement as claimed in Claim 2, 3, 4 or 5, characterised in that the control amplifier (N4, N5, P2, P4) comprises a transistor (N4) having a first main electrode connected to the first supply-voltage terminal (2), a second main electrode to the output (VO), and the control electrode to the second main electrode of the first transistor (N1) *via* a diode-connected transistor (N6) of the adaptation means.

7. An amplifier arrangement as claimed in Claim 2, 3, 4 or 5, characterised in that the adaptation means (N6, N7, N8) comprise three series-connected transistors (N6, N7, N8) which in combination with the first transistor (N1) form a current path between the first supply-voltage terminal ad a second supply-voltage terminal, which current path is supplied with current from an output of the current mirror, the first transistor (N1) and said series-connected transistors being of the same conductivity type, a first series transistor (N8) connected to the output of the current mirror being connected as a diode, a control electrode of the second series transistor (N7) being connected to the control electrode of the first series transistor (N8), the control electrode of the third series transistor (N6) being connected to the node between the main electrodes of the first and the second series transistor (N7, N8), and the node between the main electrodes of the second and the third series transistor (N6, N7) being connected to the inverting input of the control amplifier (N4).

8. An amplifier arrangement as claimed in Claim 7, characterised in that the control amplifier (N4, N5, P4, P2) is a cascoded amplifier having a first and a second amplifier transistor (N4, N5) of a first conductivity type and a first and a second amplifier transistor (P4, P2) of a second conductivity type which form a current path between the first and the second supply-voltage terminal, the node between the second transistors (N5, P4) of a different conductivity type forming the output (VO) of the control amplifier, the control electrodes of the second transistors (N5, P4) of the control amplifier being connected to the control electrode of the third series transistor (N6), and a main electrode and the control electrode of the amplifier transistor of the first conductivity type respectively being connected to the first supply-voltage terminal and forming the inverting input of the control amplifier.

9. An amplifier arrangement as claimed in Claim 2, 3, 4, 5, 6, 7 or 8, characterised in that the current-sensing circuit comprises a current-sensing transistor (N3) of the same conductivity type as the first transistor (N1), the first main electrode and the control electrode of the current-sensing transistor (N3) being connected respectively to the first main electrode and the control electrode of the first transistor (N1).

10. An amplifier arrangement as claimed in Claim 9, characterised in that the second main electrode of the current-sensing transistor (N3) is connected to a first main electrode of a first current-mirror transistor (P1) having its second main electrode connected to the second supply-voltage terminal and its control electrode to the first main electrode.

11. An amplifier arrangement as claimed in Claim 10, characterised in that the current mirror comprises three current-mirror transistors (P1, P2, P3) whose second and third current-mirror transistor feed a current proportional to the current through the current-sensing transistor into the current path of the adaptation means and the control amplifier respectively.

12. An integrated circuit comprising a plurality of amplifier arrangements as claimed in any one of the preceding Claims, characterised in that there is provided at least a first and a second amplifier arrangement of a first and a second type respectively, the transistors of the amplifier arrangement of the first type being complementary to the transistors of the amplifier arrangement of the second type.

**Patentansprüche**

1. Verstärkeranordnung mit einem ersten Transistor (N1) mit einer mit einer Eingangsklemme (1) zum Empfangen eines Eingangssignals (Vin) gekoppelten Steuerelektrode, mit einer mit einer ersten Speiseklemme (2) gekoppelten ersten Hauptelektrode und einer zweiten Hauptelektrode, einem zweiten Transistor (N2) mit einer Steuerelektrode, einer mit der zweiten Hauptelektrode des ersten Transistors (N1) gekoppelten ersten Hauptelektrode und einer mit einer Ausgangsklemme (4) zum Liefern eines Ausgangssignals (Vout) gekoppelten zweiten Hauptelektrode, und mit einem Steuerverstärker (N4, N5, P2, P4), der einen mit der zweiten Hauptelektrode des ersten Transistors (N1) gekoppelten invertierenden Eingang (V1) und einen mit einer Bezugsspannung gekoppelten nicht-invertierenden Eingang hat und einen mit der Steuerelektrode des zweiten Transistors (N2) gekoppelten Ausgang (VO), dadurch gekennzeichnet, daß die Verstärkeranordnung weiterhin Korrekturmittel (N3, N6, N7, N8, P1, P2, P3, P4) umfaßt zum Korrigieren eines ersten Potentials an der zweiten Hauptelektrode des ersten Transistors (N1) in Abhängigkeit von einem zweiten Potential an der Steuerelektrode des ersten Transistors (N1), in solcher Weise, daß im Betrieb der erste Transistor (N1) auf einem gewünschten Sättigungspunkt gehalten wird.

2. Verstärkeranordnung nach Anspruch 1, dadurch gekennzeichnet, daß die Korrekturmittel Anpassungsmittel (N6, N7, N8) und eine Stromaufnehmerschaltung (N3) zum Generieren eines mit einem Strom durch den ersten Transistor (N1) zusammenhängenden Stroms umfassen, wobei die Anpassungsmittel (N6, N7, N8) mit Hilfe des von der Aufnehmerschaltung generierten Stroms angesteuert werden, um das erste Potential anzupassen.

3. Verstärkeranordnung nach Anspruch 1 oder 2, dadurch gekennzeichnet, daß die Korrekturmittel eine Stromspiegelschaltung (P1, P2, P3) zum Generieren eines mit einem Strom durch den ersten Transistor (N1) zusammenhängenden Stroms umfassen, wobei die Anpassungsmittel (N6, N7, N8) mit Hilfe des von der Stromspiegelschaltung (P1, P2, P3) generierten Stroms angesteuert werden, um das erste Potential anzupassen.

4. Verstärkeranordnung nach Anspruch 2 oder 3, dadurch gekennzeichnet, daß die Anpassungsmittel (N6, N7, N8) zumindest einen Transistor (N6) umfassen, der zusammen mit dem ersten Transistor (N1) einen Strompfad zwischen der ersten und einer zweiten Speisespannungsklemme bildet, welcher Strompfad mit Strom aus einem Ausgang (P3) des Stromspiegels (P1, P2, P3) gespeist wird, wobei der erste Transistor (N1) und die genannten Transistoren der Anpassungsmittel vom gleichen Leitungstyp sind.

5. Verstärkeranordnung nach Anspruch 2, 3 oder 4, dadurch gekennzeichnet, daß der Steuerverstärker (N4, N5, P4, P2) mit Strom aus einem weiteren Ausgang (P2) des Stromspiegels (P1, P2, P3) gespeist wird.

6. Verstärkeranordnung nach Anspruch 2, 3, 4 oder 5, dadurch gekennzeichnet, daß der Steuerverstärker (N4, N5, P2, P4) einen Transistor (N4) mit einer mit der ersten Speisespannungsklemme (2) verbundenen ersten Hauptelektrode, einer mit dem Ausgang (VO) verbundenen zweiten Hauptelektrode, und der mit der zweiten Hauptelektrode des ersten Transistors (N1) über einen als Diode geschalteten Transistor (N6) des Anpassungsmittels verbundenen Steuerelektrode umfaßt.

7. Verstärkeranordnung nach Anspruch 2, 3, 4 oder 5, dadurch gekennzeichnet, daß die Anpassungsmittel (N6, N7, N8) drei in Reihe geschaltete Transistoren (N6, N7, N8) umfassen, die zusammen mit dem ersten Transistor (N1) einen Strompfad zwischen der ersten Speisespannungsklemme und einer zweiten Speisespannungsklemme bilden, welcher Strompfad mit Strom aus einem Ausgang des Stromspiegels gespeist wird, wobei der erste Transistor (N1) und die in Reihe geschalteten Transistoren vom gleichen Leitungstyp sind, ein erster mit dem Ausgang des Stromspiegels verbundener Reihen-Transistor (N8) als Diode geschaltet ist, eine Steuerelektrode des zweiten Reihen-Transistors (N7) mit der Steuerelektrode des ersten Reihen-Transistors (N8) verbunden ist, die Steuerelektrode des dritten Reihen-Transistors (N6) mit dem Knotenpunkt zwischen den Hauptelektroden des ersten und des zweiten Reihen-Transistors (N7, N8) verbunden ist, und der Knotenpunkt zwischen den Hauptelektroden des zweiten und des dritte Reihen-Transistors (N6, N7) mit dem invertierenden Eingang des Steuerverstärkers (N4) verbunden ist.

8. Verstärkeranordnung nach Anspruch 7, dadurch gekennzeichnet, daß der Steuerverstärker (N4, N5, P4, P2) ein kaskodierter Verstärker mit einem ersten und einem zweiten Verstärker-Transistor (N4, N5) eines ersten Leitungstyps und einem ersten und einem zweiten Verstärker-Transistor (P4, P2) eines zweiten Leitungstyps ist, die einen Strompfad zwischen der ersten und der zweiten Speisespannungsklemme bilden, wobei der Knotenpunkt zwischen den zweiten Transistoren (N5, P4) eines anderen Leitungstyps den Ausgang (VO) des Steuerverstärkers bildet, die Steuerelektroden der zweiten Transistoren (N5, P4) des Steuerverstärkers mit der Steuerelektrode des dritten Reihen-Transistors (N6) verbunden sind, und eine Hauptelektrode bzw. die Steuerelektrode des Verstärkertransistors des ersten Leitungstyps mit der ersten Speisespannungsklemme verbunden ist bzw. den invertierenden Eingang des Steuerverstärkers bildet.

9. Verstärkeranordnung nach Anspruch 2, 3, 4, 5, 6, 7 oder 8, dadurch gekennzeichnet, daß die Stromaufnehmerschaltung einen Stromaufnehmertransistor (N3) vom gleichen Leitungstyp wie der erste Transistor (N1) umfaßt, wobei die erste Hauptelektrode bzw. die Steuerelektrode des Stromaufnehmertransistors (N3) mit der ersten Hauptelektrode bzw. der Steuerelektrode des ersten Transistors (N1) verbunden ist.

10. Verstärkeranordnung nach Anspruch 9, dadurch gekennzeichnet, daß die zweite Hauptelektrode des Stromaufnehmertransistors (N3) mit einer ersten Hauptelektrode eines ersten Stromspiegeltransistors (P1) verbunden ist, dessen zweite Hauptelektrode mit der zweiten Speisespannungsklemme und dessen Steuerelektrode mit der ersten Hauptelektrode verbunden ist.

11. Verstärkeranordnung nach Anspruch 10, dadurch gekennzeichnet, daß der Stromspiegel drei Stromspiegeltransistoren (P1, P2, P3) umfaßt, deren zweiter und dritter Stromspiegeltransistor einen dem durch den Stromaufnehmertransistor fließenden Strom proportionalen Strom in den Strompfad der Anpassungsmittel bzw. des Steuerverstärkers einspeisen.

12. Integrierte Schaltung mit einer Vielzahl Verstärkeranordnungen nach einem der vorhergehenden Ansprüche, dadurch gekennzeichnet, daß es zumindest eine erste und eine zweite Verstärkeranordnung eines ersten bzw. eines zweiten Typs gibt, wobei die Transistoren der Verstärkeranordnung des ersten Typs zu den Transistoren der Verstärkeranordnung des zweiten Typs komplementär sind.

## Revendications

1. Circuit amplificateur comportant un premier transistor (N1) ayant une électrode de commande couplée à une borne d'entrée (1) pour recevoir un signal d'entrée (Vin), ayant une première électrode principale couplée à une première borne de tension d'alimentation (2) et présentant une deuxième électrode principale, un deuxième transistor (N2) présentant une électrode de commande, ayant une première électrode principale couplée à la deuxième électrode principale du premier transistor (N1) et ayant une deuxième électrode principale couplée à une borne de sortie (4) pour fournir un signal de sortie (Vout), et un amplificateur de commande (N4, N5, P2, P4) ayant une entrée inverseuse (V1) couplée à la deuxième électrode principale du premier transistor (N1) et une entrée non inverseuse couplée à une tension de référence, et ayant une sortie (VO) couplée à l'électrode de commande du deuxième transistor (N2), caractérisé en ce que le circuit amplificateur comporte encore des moyens de correction (N3, N6, N7, N8, P1, P2, P3, P4) pour corriger un premier potentiel présent sur la deuxième électrode principale du premier transistor (N1) en fonction d'un deuxième potentiel présent sur l'électrode de commande du premier transistor (N1) d'une telle manière qu'en fonctionnement le premier transistor (N1) soit maintenu à un point de saturation souhaité.

2. Circuit amplificateur selon la revendication 1, caractérisé en ce que les moyens de correction comportent des moyens d'adaptation (N6, N7, N8) et un circuit détecteur de courant (N3) pour engendrer un courant ayant rapport à un courant traversant le premier transistor (N1), les moyens d'adaptation (N6, N7, N8) étant commandés au moyen du courant engendré par le circuit détecteur pour adapter le premier potentiel.

3. Circuit amplificateur selon la revendication 1 ou 2, caractérisé en ce que les moyens de correction comportent un circuit de miroir de courant (P1, P2, P3) pour engendrer un courant ayant rapport à un courant traversant le premier transistor (N1), les moyens d'adaptation (N6, N7, N8) étant commandés au moyen dudit courant engendré par le circuit de miroir de courant (P1, P2, P3) pour adapter le premier potentiel.

4. Circuit amplificateur selon la revendication 2 ou 3, caractérisé en ce que les moyens d'adaptation (N6, N7, N8) comportent au moins un transistor (N6) qui en combinaison avec le premier transistor (N1) constitue un trajet de courant situé entre la première et une deuxième borne de tension d'alimentation, ledit trajet de courant est alimenté en courant à partir d'une sortie (P3) du miroir de courant (P1, P2, P3), le premier transistor (N1) et lesdits transistors des moyens d'adaptation étant du même type de conductivité.

5. Circuit amplificateur selon la revendication 2, 3 ou 4, caractérisé en ce que l'amplificateur de commande (N4, N5, P4, P2) est alimenté en courant à partir d'une autre sortie (P2) du miroir de courant (P1, P2, P3).

6. Circuit amplificateur selon la revendication 2, 3, 4 ou 5, caractérisé en ce que l'amplificateur de commande (N4, N5, P2, P4) comporte un transistor (N4) ayant une première électrode principale reliée à la première borne de tension d'alimentation (2), une deuxième électrode principale reliée à la sortie (VO) et l'électrode de commande reliée à la deuxième électrode principale du premier transistor (N1) par l'intermédiaire d'un transistor connecté en diode (N6) des moyens d'adaptation.

7. Circuit amplificateur selon la revendicaton 2, 3, 4 ou 5, caractérisé en ce que les moyens d'adaptation (N6, N7, N8) comportent trois transistors connectés en série (N6, N7, N8) qui en combinaison avec le premier transistor (N1) constituent un trajet de courant situé entre la première borne de tension d'alimentation et une deuxième borne de tension d'alimentation, ledit trajet de courant est alimenté en courant à partir d'une sortie du miroir de courant, le premier transistor (N1) et lesdits transistors connectés en série étant du même type de conductivité, un premier transistor série (N8) relié à la sortie du miroir de courant étant connecté en diode, une électrode de commande du deuxième transistor série (N7) étant reliée à l'électrode de commande du premier transistor série (N8), l'électrode de commande du troisième transistor série (N6) étant reliée au noeud situé entre les électrodes principales des premier et deuxième transistors série (N7, N8), et le noeud situé entre les électrodes principales des deuxième et troisième transistors série (N6, N7) étant relié à l'entrée inverseuse de l'amplificateur de commande (N4).

8. Circuit amplificateur selon la revendication 7, caractérisé en ce que l'amplificateur de commande (N4, N5, P4, P2) est un amplificateur cascodé (en cascode) présentant des premier et deuxième transistors amplificateurs (N4, N5) d'un premier type de conductivité et des premier et deuxième transistors amplificateurs (P4, P2) d'un deuxième type de conductivité qui constituent un trajet de courant situé entre les première et deuxième bornes de tension d'alimentation, le noeud situé entre les deuxièmes transistors (N5, P4) d'un type de conductivité différent constituant la sortie (VO) de l'amplificateur de commande, les électrodes de commande des deuxièmes transistors (N5, P4) de l'amplificateur de commande étant reliées à l'électrode de commande du troisième transistor série (N6), et une électrode principale et l'électrode de commande du transistor amplificateur du premier type de conductivité étant reliées à la première borne de tension d'alimentation respectivement constituant l'entrée inverseuse de l'amplificateur de commande.

9. Circuit amplificateur selon la revendication 2, 3, 4, 5, 6, 7 ou 8, caractérisé en ce que le circuit détecteur de courant comporte un transistor détecteur de courant (N3) du même type de conductivité que le premier transistor (N1), la première électrode principale et l'électrode de commande du transistor détecteur de courant (N3) étant reliées à la première électrode principale respectivement à l'électrode de commande du premier transistor (N1).

**10.** Circuit amplificateur selon la revendication 9, caractérisé en ce que la deuxième électrode principale du transistor détecteur de courant (N3) est reliée à une première électrode principale d'un premier transistor de miroir de courant (P1) ayant sa deuxième électrode principale reliée à la deuxième borne de tension d'alimentation et son électrode de commande à la première électrode principale.

**11.** Circuit amplificateur selon la revendication 10, caractérisé en ce que le miroir de courant comporte trois transistors de miroir de courant (P1, P2, P3) dont les deuxième et troisième transistors de miroir de courant envoient un courant proportionnel au courant traversant le transistor détecteur de courant dans le trajet de courant des moyens d'adaptation respectivement de l'amplificateur de commande.

**12.** Circuit intégré comportant une pluralité de circuits amplificateurs selon l'une quelconque des revendications précédentes, caractérisé en ce qu'il est fourni au moins un premier et un deuxième circuit amplificateur d'un premier respectivement d'un deuxième type, les transistors du circuit amplificateur du premier type étant complémentaires aux transistors du circuit amplificateur du deuxième type.

F IG.1

FIG.2